Europäisches Patentamt

European Patent Office

Office européen des brevets

(19)

(11) Numéro de publication: **0 083 890**
**A1**

## (12) DEMANDE DE BREVET EUROPEEN

(21) Numéro de dépôt: **82402365.9**

(22) Date de dépôt: **23.12.82**

(51) Int. Cl.$^3$: **H 03 K 19/082**

(30) Priorité: **28.12.81 FR 8124299**

(43) Date de publication de la demande:
**20.07.83 Bulletin 83/29**

(84) Etats contractants désignés:
**BE DE GB LU NL**

(71) Demandeur: **COMPAGNIE D'INFORMATIQUE MILITAIRE SPATIALE ET AERONAUTIQUE
25, rue de Courcelles
F-75008 Paris(FR)**

(72) Inventeur: **Bernard-Guelle, Claude
THOMSON-CSF SCPI 173, bld. Haussmann
F-75379 Paris Cedex 08(FR)**

(72) Inventeur: **Gerard, André
THOMSON-CSF SCPI 173, bld. Haussmann
F-75379 Paris Cedex 08(FR)**

(74) Mandataire: **Benoit, Monique et al,
THOMSON-CSF SCPI 173, Bld Haussmann
F-75379 Paris Cedex 08(FR)**

(54) Dispositif de commutation de tensions analogiques à commande logique.

(57) L'invention a pour objet un dispositif permettant d'engendrer une parmi N tensions analogiques prédéfinies à partir d'une unique tension d'alimentation, sur commande logique.

Ce dispositif comporte principalement un circuit (1) d'élaboration d'une tension intermédiaire prédéfinie ($V_i$); un circuit (2) d'élaboration d'une tension nulle pour une certaine valeur de la commande logique ($E_0$); un troisième circuit (3) fournissant à partir des signaux ($V_2$, $V_3$) délivrés par le circuit précédent (2) la tension analogique (S) recherchée.

FIG_1

EP 0 083 890 A1

0083890

1

# DISPOSITIF DE COMMUTATION DE TENSIONS ANALOGIQUES, A COMMANDE LOGIQUE

La présente invention a pour objet un dispositif de commutation permettant de sélectionner, par une commande de type logique, une parmi plusieurs tensions analogiques prédéfinies.

Dans certaines applications, notamment celles qui mettent en oeuvre des informations numériques, il est nécessaire de pouvoir sélectionner, pour des utilisations ultérieures, une tension analogique déterminée dans un ensemble de plusieurs (N) tensions analogiques prédéfinies, et ce par une commande constituée par une information de type logique. Une solution consiste à utiliser N générateurs de tensions analogiques et de réaliser simplement la commutation à l'aide d'interrupteurs entre ces générateurs ; cette solution est à la fois encombrante et onéreuse.

La présente invention a pour objet un dispositif fournissant, à partir d'une seule tension d'alimentation analogique, une parmi N tensions analogiques prédéfinies, sur une commande logique constituée de N-1 informations pouvant prendre chacune une parmi deux valeurs, reçues en parallèle.

Plus précisément, le dispositif selon l'invention a pour objet un dispositif de commutation de tensions analogiques, à commande logique, comportant :

– au moins un premier circuit recevant une tension d'alimentation et une première information logique et fournissant une première tension analogique intermédiaire correspondant, selon la valeur de la première information logique, soit à la tension d'alimentation soit à une tension prédéfinie ;

– un deuxième circuit, recevant la tension intermédiaire et une deuxième information logique, et dont les sorties dépendent de la valeur de la deuxième information logique : pour la première sortie, soit elle est en circuit ouvert, soit elle fournit une deuxième tension analogique intermédiaire, et pour la deuxième sortie, elle fournit une tension correspondant soit à la première soit à la deuxième tension analogique intermédiaire ;

- un troisième circuit, connecté aux sorties du circuit précédent et recevant en outre la tension d'alimentation, fournissant la tension de sortie du dispositif qui correspond à la première tension intermédiaire lorsque la sortie du deuxième circuit est en circuit ouvert, et à la deuxième tension intermédiaire, fournie par le deuxième circuit dans le cas contraire.

L'invention sera mieux comprise à l'aide de la description ci-après, donnée à titre d'exemple non limitatif et illustrée par les dessins annexés qui représentent :

- la figure 1, le schéma général du dispositif selon l'invention ;

- la figure 2, un mode de réalisation de l'un des ensembles de la figure précédente ;

- la figure 3, un mode de réalisation d'un deuxième ensemble de la figure 1 ;

- la figure 4, un mode de réalisation d'un troisième ensemble du dispositif de la figure 1.

Sur ces différentes figures, les mêmes références se rapportent aux mêmes éléments.

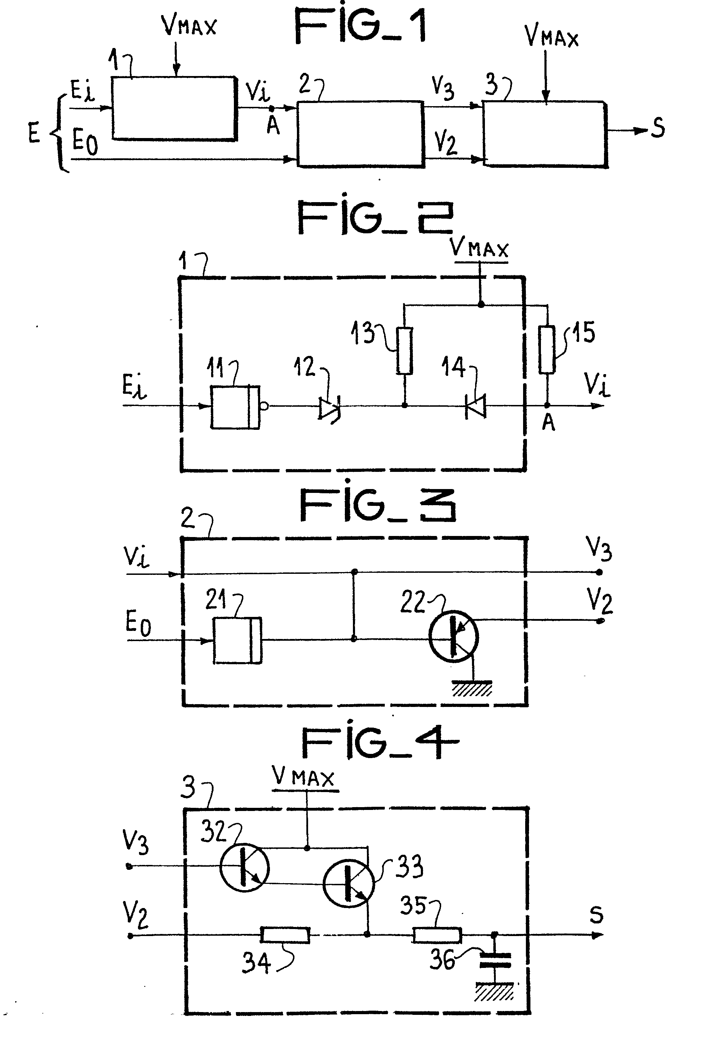

Sur la figure 1, on a représenté un circuit 1 recevant une information de type logique, c'est-à-dire pouvant prendre une parmi deux valeurs prédéfinies, notée $E_i$, et une tension $V_{MAX}$, constituant la tension d'alimentation du dispositif ; ce circuit 1 fournit sur sa sortie (point A) une tension analogique, appelée tension intermédiaire et notée $V_i$.

Le dispositif de la figure 1 comporte un deuxième circuit, repéré 2, recevant d'une part une seconde information de type logique $E_0$ et d'autre part la tension intermédiaire $V_i$ précédente ; les deux sorties de ce circuit 2 sont notées $V_2$ et $V_3$.

Le dispositif de la figure 1 comporte enfin un troisième circuit 3, connecté aux sorties du circuit 2, et recevant par ailleurs la tension d'alimentation $V_{MAX}$ ; ce circuit 3 a pour fonction de fournir à partir de $V_3$ et $V_2$ la tension analogique de sortie S du dispositif qui correspond à la commande logique E reçue, E repré-

sentant l'ensemble $E_i$ et $E_0$.

Le fonctionnement de ce dispositif est le suivant :

- Pour l'une des valeurs de $E_i$, par exemple $E_i = 1$, le circuit 1 élabore à partir de la tension $V_{MAX}$ une tension de valeur prédéfinie, $V_p$ inférieure à $V_{MAX}$, et pour l'autre valeur de $E_i$, par exemple $E_i = 0$, ne fait que transmettre au point A la tension $V_{MAX}$, aux chutes ohmiques près intervenant dans le circuit 1. Dans la suite de la description, on dira alors dans ce cas que $V_i$ correspond à $V_{MAX}$.

- Le circuit 2, pour l'une des valeurs de $E_0$, par exemple $E_0 = 0$, élabore des tensions de sortie $V_2$ et $V_3$ sensiblement égales à 0 volt, et pour l'autre valeur de $E_0$ ($E_0 = 1$) présente une sortie $V_2$ en circuit ouvert et une sortie $V_3$ égale à $V_i$.

- Le circuit 3 élabore la tension de sortie S du dispositif dont la valeur correspond à la tension $V_i$, c'est-à-dire qui lui est sensiblement égale aux chutes ohmiques près intervenant dans le circuit 3, lorsque la sortie $V_2$ du circuit 2 est en circuit ouvert et, dans le cas contraire, ($V_2 = 0$ volt) fournit une tension de sortie S égale à 0 volt.

Le fonctionnement du dispositif peut être résumé par le tableau suivant.

TABLEAU 1

| $E_0$ | $E_i$ | S |
|-------|-------|---|
| 0 | 0 | 0 volt |
| 0 | 1 | 0 volt |
| 1 | 0 | $S_{MAX}$ |
| 1 | 1 | $S_p$ |

4

Dans ce tableau, on a noté $S_{MAX}$ la valeur de S correspondant à la tension $V_{MAX}$ et $S_p$ la valeur de S correspondant à la tension $V_p$.

Il en ressort qu'il est possible d'obtenir trois valeurs distinctes pour la tension de sortie (S) à partir de deux informations logiques $E_0$ et $E_i$.

Le dispositif de la figure 1 peut être généralisé à la fourniture de N tensions analogiques à partir de N-1 informations logiques. A cet effet, on dispose N-2 circuits analogues au circuit 1, recevant chacun la tension $V_{MAX}$ et une information logique $(E_1...E_{N-2})$ et fournissant chacun une tension de sortie $(V_1...V_{N-2})$, les sorties des N-2 circuits étant reliées au point A de la figure 1. Le fonctionnement du dispositif est identique au précédent, c'est-à-dire que le circuit 3 fournit soit une tension nulle lorsque le circuit 2 fournit une tension $(V_3)$ nulle soit, dans le cas contraire, une tension correspondant à la tension de sortie de celui des circuits 1 qui reçoit une information logique (E) égale à 1.

A titre d'exemple, on a représenté dans le tableau II des tensions de sortie obtenues à l'aide de quatre circuits tels que 1.

TABLEAU II

| $E_0$ | $E_1$ | $E_2$ | $E_3$ | $E_4$ | S |
|---|---|---|---|---|---|
| 0 | valeur | indifférente | | | 0 volt |
| | 0 | 0 | 0 | 0 | $S_{MAX}$ |
| | 0 | 0 | 0 | 1 | $S_4$ |
| 1 | 0 | 0 | 1 | 0 | $S_3$ |
| | 0 | 1 | 0 | 0 | $S_2$ |
| | 1 | 0 | 0 | 0 | $S_1$ |

Dans ce tableau, on a noté $S_1...S_4$ les valeurs de S correspondant aux tensions respectivement de celui des quatre circuits qui reçoit une information logique ($E_1...E_4$) égale à 1.

Il est à noter que la sélection (E = 1) de plus d'un circuit tel que 1 en même temps est interdite.

La figure 2 représente un mode de réalisation du circuit 1 de la figure 1.

Le circuit 1 comporte un inverseur 11 recevant l'information logique $E_i$, cet inverseur étant du type à sortie en collecteur ouvert, c'est-à-dire par exemple constitué par un transistor dont la base constitue l'entrée de l'inverseur, l'émetteur est relié à la masse et le collecteur constitue la sortie de l'inverseur. La sortie de l'inverseur 11 est reliée à une diode Zener 12 dont la fonction est de constituer une référence de tension, à la tension $V_p$. La sortie de la diode Zener 12 est reliée d'une part à la tension $V_{MAX}$ par l'intermédiaire d'une résistance 13 fixant la tension de polarisation de la diode 12, et d'autre part au point A par l'intermédiaire d'une diode de protection 14 connectée dans le sens passant de A vers l'entrée $E_i$, nécessaire lors de la mise en parallèle de plusieurs circuits 1 en A. Le point A est en outre relié à la tension $V_{MAX}$ par l'intermédiaire d'une résistance 15.

Le fonctionnement de ce circuit est le suivant :

- Lorsque le signal $E_i$ a la valeur 0, la sortie de l'inverseur 11 est en état de haute impédance, correspondant à un état logique 1 et la diode 12 n'est alors pas polarisée. La tension $V_i$ obtenue en A correspond donc à la tension $V_{MAX}$, c'est-à-dire est de l'ordre de $V_{MAX}$, aux chutes de tension près dans la résistance 15.

- Lorsque $E_i$ est égal à 1, l'inverseur fournit un état logique 0, représenté par un potentiel nul et la diode Zener 12 limite alors la tension $V_i$ à une valeur prédéfinie, égale à $V_p$ aux chutes de tension près dans la diode 14. A titre indicatif, cette chute est couramment inférieure au volt.

Il apparaît ainsi que la tension $V_i$ de sortie du circuit 1 peut prendre deux valeurs selon la valeur de l'information $E_i$ : soit une valeur correspondant à la tension $V_{MAX}$, soit une valeur $V_p$ définie par la diode Zener 12. Il en ressort que dans le cas de plusieurs circuits tels que 1 en parallèle, comme décrit plus haut, ceux-ci peuvent avoir des structures tout à fait identiques, aux caractéristiques de la diode Zener 12 et de sa résistance 13 près.

La figure 3 représente un mode de réalisation du circuit 2 de la figure 1.

Ce circuit comporte un élément 21 dont la sortie est du type collecteur ouvert, analogue à l'élément 11 de la figure 2 à ceci près qu'il n'est pas inverseur ; il reçoit la commande $E_0$ et sa sortie est reliée à la base d'un transistor 22. La sortie de l'élément 21 est également reliée au point A de la figure 1 afin de recevoir le potentiel $V_i$. Le collecteur du transistor 22 est relié à la masse alors que son émetteur constitue la sortie $V_2$ du circuit 2. La sortie $V_3$ est constituée par le point commun des éléments 21 et 22.

En fonctionnement :

- Lorsque le signal $E_0$ est égal à 0, la sortie de l'élément 21 est portée à un potentiel nul, à la chute de tension près dans l'étage de sortie (collecteur-émetteur) de l'élément 21. Le potentiel $V_i$ qui prend la valeur (presque nulle) du potentiel de sortie de l'élément 21, d'une part constitue le potentiel $V_3$ ( $\simeq 0$) et d'autre part est transmis à la base du transistor 22 ; celui-ci étant alors conducteur, la sortie $V_2$ se trouve reliée à la masse et son potentiel est alors de 0 volt à la chute de tension près dans la jonction base-émetteur de l'élément 22 ;

- lorsque le signal $E_0$ est égal à 1, la sortie de l'élément 21 est à haute impédance, $V_3 = V_i$ et la base du transistor 22 reçoit le potentiel $V_i$ ; le transistor 22 n'étant alors pas conducteur à cause de la connexion qu'il existe entre $V_3$ et $V_2$ dans le circuit 3 (décrit figure 3) qui rend $V_2$ inférieur à $V_i$, son émetteur ($V_2$) est alors en circuit ouvert.

Il apparaît donc que les sorties $V_2$ et $V_3$ ne fournissent un potentiel intermédiaire, sensiblement égal à 0 volt dans cette réalisation, que lorsque la commande logique $E_0$ est égale à 0.

La figure 4 représente un mode de réalisation du circuit 3 de la figure 1.

Ce circuit comporte deux transistors 32 et 33 montés en DARLINGTON, leur collecteur étant relié à la tension $V_{MAX}$ ; la base du premier transistor (32) reçoit la tension $V_3$ ; l'émetteur du second transistor (33) est relié d'une part à la sortie $V_2$ du circuit 2 par l'intermédiaire d'une résistance 34 et d'autre part à une résistance 35 dont l'autre borne constitue la sortie S du dispositif. Dans un mode de réalisation, une capacité 36 de découplage peut être ajoutée entre la sortie de la résistance 35 et la masse.

Le fonctionnement de ce circuit est le suivant :

- Lorsque la sortie $V_2$ du circuit 2 est en circuit ouvert, la sortie S du dispositif prend, par l'intermédiaire des transistors 32 et 33, une valeur correspondant à la tension $V_3=V_i$ reçue du circuit 1 (aux chutes de potentiel près) ;

- lorsque la sortie du circuit 2 fournit un potentiel $V_2$ égal à 0 volt, le potentiel $V_3$ étant dans ce cas aussi approximativement égal à 0 volt, la sortie S prend la valeur 0 volt.

A titre d'exemple, un dispositif tel que celui qui vient d'être décrit a été réalisé avec les valeurs suivantes : une tension d'alimentation $V_{MAX}$ égale à 28 volts ; deux circuits tels que 1 comportant des diodes Zener limitant la tension respectivement à 5 volts et 12 volts ; une résistance 15 de l'ordre de 2,7 KOhms, des résistances 34 et 35 de l'ordre de 50 Ohms.

8

# REVENDICATIONS

1. Dispositif de commutation de tensions analogiques, à commande logique, caractérisé par le fait qu'il comporte :

- au moins un premier circuit (1) recevant une tension d'alimentation ($V_{MAX}$) et une première information logique ($E_i$) et fournissant une première tension analogique intermédiaire ($V_i$) correspondant, selon la valeur de la première information logique ($E_i$), soit à la tension d'alimentation ($V_{MAX}$), soit à une tension prédéfinie ($V_p$) ;

- un deuxième circuit (2), recevant la tension intermédiaire ($V_i$) et une deuxième information logique ($E_0$), et dont les sorties dépendent de la valeur de la deuxième information logique ($E_0$) : pour la première sortie ($V_2$), soit elle est en circuit ouvert, soit elle fournit une deuxième tension analogique intermédiaire, et pour la deuxième sortie ($V_3$), elle fournit une tension correspondant soit à la première ($V_i$) soit à la deuxième tension analogique intermédiaire ;

- un troisième circuit (3), connecté aux sorties du circuit précédent (2) et recevant en outre la tension d'alimentation ($V_{MAX}$), fournissant la tension de sortie (S) du dispositif qui correspond à la première tension intermédiaire ($V_i$) lorsque la sortie ($V_2$) du deuxième circuit (2) est en circuit ouvert, et à la deuxième tension intermédiaire, fournie par le deuxième circuit (2) dans le cas contraire.

2. Dispositif selon la revendication 1, caractérisé par le fait que la deuxième tension intermédiaire est sensiblement nulle.

3. Dispositif selon l'une des revendications précédentes, caractérisé par le fait que la première tension intermédiaire ($V_i$) a une valeur prédéfinie inférieure à celle de la tension d'alimentation ($V_{MAX}$).

4. Dispositif selon l'une des revendications précédentes, caractérisé par le fait que le premier circuit (1) comporte un inverseur (11) du type à collecteur ouvert, recevant la première information logique ($E_i$), dont la sortie est reliée à une diode Zener (12) définissant la tension prédéfinie ($V_p$), dont l'autre borne d'une part est reliée à la tension d'alimentation ($V_{MAX}$) par l'intermédiaire d'un premier élément résistif (13) et d'autre part constitue la borne de sortie (A) du premier circuit (1), elle-même reliée à la tension d'alimentation ($V_{MAX}$) par l'intermédiaire d'un second élément résistif (15).

5. Dispositif selon la revendication 4, caractérisé par le fait que le premier circuit (1) comporte en outre une diode de protection (14), connectée dans le sens passant entre la borne de sortie (A) du premier circuit et l'autre borne de la diode Zener (12), les deux bornes de la diode de protection (14) se trouvant ainsi respectivement reliées à la tension d'alimentation ($V_{MAX}$) par l'intermédiaire des deux éléments résistifs (13, 15).

6. Dispositif selon l'une des revendications précédentes, caractérisé par le fait que le deuxième circuit (2) comporte un élément non inverseur (21) du type à collecteur ouvert, à la sortie duquel est connectée la base d'un transistor (22) dont l'émetteur est relié à la masse et le collecteur constitue la première sortie ($V_2$) du deuxième circuit, le point commun à l'élément non inverseur (21) et au transistor (22) recevant la première tension intermédiaire ($V_i$) et étant relié à la deuxième sortie ($V_3$) du deuxième circuit.

7. Dispositif selon l'une des revendications précédentes, caractérisé par le fait que le troisième circuit (3) comporte deux transistors (32, 33) connectés selon le montage DARLINGTON, leurs collecteurs recevant la tension d'alimentation ($V_{MAX}$), la base du premier transistor (32) étant connectée à la deuxième sortie ($V_3$) du deuxième circuit (2) et l'émetteur du deuxième transistor (33) d'une

10

part étant connecté à la première sortie ($V_2$) du deuxième circuit (2) et, d'autre part, constituant la sortie (S) du dispositif par l'intermédiaire d'un élément résistif (35).

8. Dispositif selon l'une des revendications précédentes, caractérisé par le fait qu'il comporte une pluralité (N-2) de circuits tels que le premier circuit (1), chacun d'eux étant caractérisé par une diode Zener (12) définissant une tension prédéfinie ($V_p$) distincte, chacun de ces circuits étant relié par leur sortie à la même borne d'entrée du deuxième circuit (2), le dispositif fournissant ainsi N tensions analogiques distinctes.

# FIG_1

V MAX

V MAX

E { Ei, E0 }  [1]  Vi  A  [2]  V3, V2  [3]  → S

# FIG_2

[1]

V MAX

Ei  [11]  [12]  [13]  [14]  [15]  Vi  A

# FIG_3

[2]

Vi  →  V3

E0  [21]  [22]  V2

# FIG_4

[3]

V MAX

V3  [32]  [33]

V2  [34]  [35]  [36]  → S

Office européen
des brevets

**RAPPORT DE RECHERCHE EUROPEENNE**

**0083890**

Numéro de la demande

EP   82 40 2365

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| A | PROCEEDINGS OF THE TENTH INTERNATIONAL SYMPOSIUM ON MULTIPLE-VALUED LOGIC, 1980, Northwestern University, pages 31-35, Evanston, USA<br>D. ETIEMBLE et al.: "T.S.C. multivalued TTL circuits" * Figure 1; table 1; page 32, colonne de gauche, lignes 14-20 * | 1 | H 03 K   19/082 |

-----

**DOMAINES TECHNIQUES RECHERCHES (Int. Cl. ³)**

H 03 K

Le présent rapport de recherche a été établi pour toutes les revendications

| Lieu de la recherche | Date d'achèvement de la recherche | Examinateur |
|---|---|---|
| LA HAYE | 31-03-1983 | FEUER F.S. |